# EUROPÄISCHE PATENTSCHRIFT

(11) **EP 3 973 570 B1**
(45) Veröffentlichungstag und Bekanntmachung des Hinweises auf die Patenterteilung: **15.02.2023**
(21) Anmeldenummer: 20725142.2
(22) Anmeldetag: 07.05.2020
(51) Int. Cl.: H01L 23/367, H01L 23/498, H01L 23/538

(54) **ELEKTRONIKBAUGRUPPE UND ELEKTRONIKANORDNUNG**
ELECTRONIC ASSEMBLY AND ELECTRONIC ARRANGEMENT
BLOC ÉLECTRONIQUE ET SYSTÈME ÉLECTRONIQUE

(30) Priorität: 20.05.2019 DE 102019207341
(43) Veröffentlichungstag der Anmeldung: 30.03.2022
(73) Patentinhaber: Robert Bosch GmbH, 70442 Stuttgart (DE)
(72) Erfinder: BRAUN, Gerhard, 72108 Rottenburg (DE); MOELLER, Markus, 72793 Pfullingen (DE); AYDOGMUS, Irfan, 72622 Nuertingen (DE)
(86) Internationale Anmeldenummer: PCT/EP2020/062703
(87) Internationale Veröffentlichungsnummer: WO 2020/233997

(56) Entgegenhaltungen:
- JP-A- 2000 150 577
- US-A1- 2012 001 329
- US-B1- 6 724 084

## Beschreibung

Die Erfindung betrifft eine Elektronikbaugruppe und eine zumindest die eine Elektronikbaugruppe umfassende Elektronikanordnung gemäß dem Oberbegriff der unabhängigen Ansprüche.

### Stand der Technik

Elektronische Schaltungen werden auf Trägersubstraten ausgebildet, beispielsweise auf einer Standard-Leiterplatte aus FR4-Material. Die elektronische Schaltung umfasst dabei eine Leiterstruktur, über welche elektronische Bauelemente elektrisch miteinander kontaktiert sind.

Die Trägersubstrate werden dann zur Montage beispielsweise in ein Gehäuse geschraubt oder genietet, um mit diesem eine feste mechanische Verbindung zu erreichen. Alternativ bestehen auch Überlegungen, derartige Verbindungen durch einen Stoffschluss zu realisieren und die Leiterplatte hierbei zu verkleben. Ein solches Kleben erfordert jedoch zwingend eine kontrollierte, gute Oberflächenqualität. Dies ist insbesondere maßgeblich, wenn die Klebung auch mechanische Lasten übertragen soll (Strukturklebung). Dieser Forderung nach einer hohen Oberflächenqualität stehen jedoch einige Punkte entgegen, die aus der bisher bekannten Aufbau- und Verbindungstechnik resultieren. So sind beispielsweise die unterschiedlichen typischen metallischen Leitoberflächen von Leiterplatten (beispielsweise Gold, Kupfer, Zinn u.a.) bzw. deren Beschichtungen (OSP, Lötstopplack, u.a.) eher problematisch für strukturelle Klebverbindungen. Insbesondere zeigt sich in der Regel ein schlechtes Haftungsvermögen dieser Oberflächen bzw. Beschichtungen, wodurch es im Betrieb, insbesondere durch Temperaturwechsel und mechanische Krafteinwirkungen, über die Zeit zu Rissbildungen und/oder Delamination kommt. Ferner bedingt die Herstellung von Leiterplatten oft die Verwendung von Medien, die nachträglich nachteilig auf die Klebungen einwirken bis hin zur Zerstörung der Klebereigenschaften. Eine Prozesskontrolle, die eine nachträgliche Reinigung der Leiterplatten von diesen Prozessmedien sicherstellt, ist extrem aufwändig und bei den Herstellern oft nicht implementiert. Insgesamt ist damit die Betriebsfestigkeit einer Strukturklebung nur sehr schwer abzusichern bzw. zu garantieren. US 2012/0001329 A1 offenbart eine Elektronikbaugruppe umfassend zumindest ein Trägersubstrat, wobei auf zumindest einer Trägersubstratoberfläche eine elektronische Schaltung ausgebildet ist, wobei die Elektronikbaugruppe zumindest einen mechanischen Verbindungsdom umfasst, welcher in einem Substratverbindungsbereich mit zumindest einer der Trägersubstratoberflächen verbunden ist.

### Offenbarung der Erfindung

### Vorteile

Der Erfindung liegt die Aufgabe zu Grunde, eine einfache und zuverlässige Last übertragende Fügeverbindung zwischen einem elektrisch bestückten Trägersubstrat und einem weiteren Fügepartner unter Ausbildung einer Elektronikanordnung sicherzustellen.

Diese Aufgabe wird durch eine Elektronikbaugruppe sowie eine zumindest die eine Elektronikbaugruppe umfassende Elektronikanordnung gemäß den unabhängigen Ansprüchen gelöst.

Ausgegangen wird von einer Elektronikbaugruppe umfassend zumindest ein Trägersubstrat, wobei auf zumindest einer Trägersubstratoberfläche eine elektronische Schaltung ausgebildet ist. Die Elektronikbaugruppe umfasst dabei zumindest einen mechanischen Verbindungsdom, welcher in einem Substratverbindungsbereich mit zumindest einer der Trägersubstratoberflächen verbunden ist. Bevorzugt ist dabei die eine dem Substratverbindungsbereich zugewandte Seite des Verbindungsdomes mit einem auf der Trägersubstratoberfläche angeordneten Metallisierungsbereich verbunden. Der verbundene Metallisierungsbereich kann dabei strukturgleich oder -ähnlich zu einer auf der Trägersubstratoberfläche ausgebildeten elektrischen Leiterstruktur ausgeführt sein, wobei insbesondere keine elektrische Verbindung zur Leiterstruktur besteht oder nicht zwingend bestehen muss. Der Verbindungsbereich kann beispielhaft auch als metallisches Inlay im Trägersubstrat eingebracht sein. Der Verbindungsdom weist dagegen auf einer dem Substratverbindungsbereich abgewandten Seite eine abschließende Grenzschicht aus einem Metalloxid auf, welche ausgebildet ist, eine Klebehaftfläche für eine Kleberschicht bereitzustellen zur Ausbildung einer geklebten Verbundanordnung mit einem Fügepartner. Vorteilhaft bieten Oxidschichten oberflächige Grenzschichten, an denen Klebstoffe hervorragend festhaftend anbinden können. Insofern stellt der so beschriebene Verbindungsdom nunmehr eine ideale Verbindungsschnittstelle der Elektronikbaugruppe zur Ausbildung einer Strukturklebung mit beliebigen Fügepartnern her. Das Metalloxid ist beispielsweise als eine oxidierte Außenschicht eines Grundmaterials aus dem elementaren Metall ausgebildet. Alternativ kann auch eine metalloxidische zumindest lokal angeordnete Außenbeschichtung auf einem haftendem Grundmaterial, beispielsweise einem Metall oder einer Metalllegierung, mit dafür bekannten Beschichtungsverfahren, beispielsweise einem Plasmabeschichtungsverfahren, aufgebracht sein.

In einer vorteilhaften Ausführungsform der Elektronikbaugruppe ist der Verbindungsdom im Wesentlichen oder zumindest auf einer der bereitgestellten Klebehaftfläche zugewandten Seite anteilig aus Aluminium oder einer Aluminiumlegierung, insbesondere einem Aluminiumoxid, gebildet. Aluminium weist den Vorteil auf, dass dessen Oberflächen einfach und gut zu reinigen sind, so dass eine definierte Fügefläche vorbereitend ausbildbar ist. Zusätzlich bilden sich auf diesen Oberflächen technisch unterstützt und/oder selbstständig langstabile, festhaftende Oxide aus, welche die Haftanbindung zu Klebstoffen sicherstellt. Insofern können Bereiche außerhalb der bereitgestellten Klebehaftfläche, insbesondere ein Kern des Verbindungsdomes, aus Aluminium gebildet sein, wogegen die bereitgestellte Klebhaftfläche aus Aluminiumoxid gebildet ist. Es ist auch denkbar aus wirtschaftlichen Überlegungen jeglichen aluminiumhaltigen Volumenanteil des Verbindungsdomes vollständig aus Aluminiumoxid vorzusehen.

In einer bevorzugten Ausbildung der Elektronikbaugruppe weist der Verbindungsdom zumindest auf der dem Substratverbindungsbereich zugewandten Seite eine aufgebrachte, festhaftende Metallisierung auf, insbesondere aus Cu, Ag, Ni, Au oder einer ihrer Legierungen. Dadurch liegt vorteilhaft eine Fügeverbindungsschnittstelle zum Trägersubstrat vor, die mit bekannten Fügeverfahren mit der Substratträgeroberfläche, insbesondere mit einem auf der Substratträgeroberfläche angeordnetem Metallisierungsbereich, fest verbindbar ist. Insgesamt ist dadurch eine hohe Krafttragfähigkeit des Verbindungsdomes durch die belastbare Fügeschnittstelle zum Trägersubstrat einerseits und durch die belastbare Klebeschnittstelle zu einem Fügepartner der Elektronikbaugruppe andererseits erreichbar. Die Metallisierung ist bevorzugt galvanisch aufgebracht ist, beispielsweise aus Ag oder einer Ag-Legierung. Eine vorteilhafte alternative Metallisierung ist durch einen auf einen Verbindungsdomkern walzplattiertes Blech gegeben. So ist beispielsweise ein Cu-Blech einseitig mit einem Verbindungsdomkern aus Aluminium walzplattiert verbunden.

Besonders vorteilhaft zeigt sich eine Ausführungsform der Elektronikbaugruppe, bei welcher der Verbindungsdom mittels einer Lotschicht oder einer Sinterschicht im Substratverbindungsbereich mit dem Trägersubstrat verbunden ist, wobei der Verbindungsdom zumindest im Substratverbindungsbereich eine zur Lotschicht oder zur Sinterschicht abschließende lötbare und/oder sinterbare Grenzschicht aufweist. Diese lötbare und/oder sinterbare Grenzschicht ist beispielsweise die zuvor genannte Metallisierung. Alternativ kann der Verbindungsdom im Wesentlichen oder zumindest die zum Substratverbindungsbereich zugewandte Seite des Verbindungsdomes aus einem lötbaren und/oder sinterbaren Kernmaterial gebildet sein, insbesondere aus einem Metall oder einer Metalllegierung, beispielsweise einem Kupfer. Vorteilhaft kann der Verbindungsdom auf diese Weise in einem bevorzugt gemeinsamen Bestückungsprozess des Trägersubstrates mit elektrischen und/oder elektronischen Bauteilen mit diesem verlötet oder versintert werden.

Eine alternative voreilhafte Ausführungsform der Elektronikbaugruppe sieht vor, dass der Verbindungsdom mittels einer kraftschlüssigen und/oder einer formschlüssigen Verbindung, insbesondere einem Einpresskontakt, im Substratverbindungsbereich mit dem Trägersubstrat verbunden ist. So kann ein Einpresspin oder eine Einpressbohrung an dem Verbindungsdom angeformt bzw. ausgeformt sein, beispielsweise an einem walzplattierten Kupferblech. Der komplementäre Einpresspartner ist dann auf Seiten des Trägersubstrates ausgebildet, beispielsweise als metallisierte Einpressbohrung oder als bereits mit dem Trägersubstrat kontaktierter Einpresspin. Die Einpresstechnik ist bereits in Serienfertigungen ein etablierter und beherrschter Fertigungsstandard.

Die Erfindung führt auch zu einer Elektronikanordnung umfassend zumindest eine erste Elektronikbaugruppe nach zumindest einer der zuvor beschriebenen Ausführungen und einem Fügepartner, wobei in einem Verbindungsbereich der Fügepartner zumindest mit dem einen Verbindungsdom mittels einer an die jeweils bereitgestellte Klebehaftfläche unmittelbar angrenzenden Klebeschicht verbunden ist. Vorteilhaft ist dadurch eine Last-übertragende Fügeverbindung herstellbar ist, welche über Lebensdauer Bestand hat. Gerade im Automobilbereich beispielsweise sind sehr hohe Anforderungen an die Betriebssicherheit von Elektronikbaugruppen und -anordnungen gestellt, da durch häufige Temperaturwechsel und/oder mechanische Krafteinwirkungen, beispielsweise Vibrationen, gängige Fügeverbindungen, insbesondere bisher bekannte Strukturklebungen bei Elektronikbaugruppen, noch innerhalb der Betriebszeit geschädigt werden können. Besonders bevorzugt werden Kleber eingesetzt wie, beispielsweise Epoxidkleber oder Silikonkleber.

In einer bevorzugten Ausführungsform der Elektronikbaugruppe ist der Fügepartner ein Gehäuseteil oder zumindest eine zweite Elektronikbaugruppe nach zumindest einer der zuvor beschriebenen Ausführungen. In einer Anordnung von zwei besagten Elektronikbaugruppen sind diese übereinander angeordnet, wobei dann der Verbindungsbereich zwischen zwei zueinander zugewandten Klebehaftflächen von jeweils einem Verbindungsdom der ersten und der zweiten Elektronikbaugruppe ausgebildet ist. Besonders bevorzugt sind die zwei verklebten Verbindungsdome jeweils mit Substratoberflächen der Trägersubstrate der ersten und der zweiten Elektronikbaugruppe verbunden, die parallel zueinander angeordnet sind, so dass eine sehr stabile und kompakte Stapelanordnung vorliegt. Prinzipiell ist auch eine Elektronikanordnung ausbildbar, bei welcher die Trägersubstrate der ersten und der zweiten Elektronikbaugruppe mittels der jeweiligen Verbindungsdome in einem Winkel zueinander, insbesondere einem senkrechten Winkel zueinander, klebend gefügt sind.

Im Falle eines Gehäuseteils als dem vorgesehenen Fügepartner ist dieses bevorzugt aus Aluminium oder einer Aluminiumlegierung. Zumindest weist das Gehäuseteil jedoch im Verbindungsbereich sachliche Merkmale auf, die denen des Verbindungsdomes für eine optimierte Strukturklebung entsprechen. So kann gehäuseseitig beispielsweise ein Prinzip gleicher Verbindungsdom angeordnet oder ausgebildet sein.

Allgemein ist zur Vereinfachungen eines Fügeprozess in Ausbildung der Elektronikanordnung vorteilhaft vorgesehen, dass eine der zueinander zugewandten Klebeflächen der Verbindungsdome die andere Klebefläche bevorzugt flächig umschließt, so dass die Elektronikanordnung trotz Fügetoleranzen sicher ausbildbar ist.

In einer besonders günstigen Ausführungsform der Elektronikanordnung umfassend zwei zuvor beschriebene Ausführungen einer elektronischen Baugruppe sind die elektronischen Schaltungen der ersten und der zweiten Elektronikbaugruppe mittels zumindest eines elektrisch leitfähigen Verbindungselementes elektrisch miteinander verbunden. Ferner weist bevorzugt die erste Elektronikbaugruppe eine Leistungsschaltung auf und weist die zweite Elektronikbaugruppe eine Ansteuerschaltung der Leistungsschaltung auf. Vorteilhaft können auf diese Weise optimierte oder zwingend erforderliche Substrattypen für die jeweilige elektronische Schaltung zur Anwendung kommen. So ist dann beispielsweise die Leistungsschaltung insbesondere auf einem DBC-, AMB- , IMS-, LTCC- oder HTCC-Trägersubstrat ausgebildet, während die Ansteuerschaltung auf einer Leiterplatte, insbesondere einer Standard-FR4-Leiterplatte, angeordnet ist. Vorteilhaft kann demnach die Elektronikanordnung im Verbund unterschiedliche Substrattypen umfassen. Zusätzlich wirken die geklebten Verbindungsdome als Wärmepfade, über welche die in der Ansteuerschaltung entstehende Wärme in das keramische Trägersubstrat der Leistungsschaltung abgeführt werden kann. Mittels der beschriebenen geklebten Elektronikanordnung ist es nun möglich, eine Ansteuerschaltung, beispielsweise auf einer FR4-Leiterplatte, sehr nah an das keramische Trägersubstrat anzuordnen, welches beispielsweise Leistungshalbleiter für eine Brückenschaltung enthält. Durch diese Nähe der Ansteuerschaltung bzw. der Treiberschaltung ist eine sehr niederinduktive und symmetrische elektrische Ansteuerung der Leistungshalbleiter möglich. Daraus resultieren deutliche Vorteile in der Leistung der Schaltung z.B. für einen Elektroantrieb. Ferner können nun auf diese Weise ansonsten sehr schwer klebbare Leiterplatten Last übertragend und über Lebensdauer hinweg innerhalb einer Elektronikanordnung strukturverklebt werden.

In einer vorteilhaften Weiterbildung der Elektronikanordnung ist das elektrische leitfähige Verbindungselement ein Bonddraht oder ein Bondbändchen. Alternativ kann auch ein Flex(flachband)kabel zum Einsatz kommen, welches beidseitig gelötet beide elektronische Schaltungen miteinander verbindet oder für die elektrische Verbindung zumindest einseitig oder beidseitig einen Steckeranschluss aufweist.

In einer fortführenden vorteilhaften Weiterbildung der Elektronikanordnung sind die Trägersubstrate der ersten und der zweiten Elektronikbaugruppe parallel übereinander angeordnet. Ferner ist auf der dem Substratverbindungsbereich abgewandten Substratoberfläche des Trägersubstrates der zweiten Elektronikbaugruppe eine erste Bondverbindungsstelle des elektrisch leitfähigen Verbindungselementes ausgebildet. Dabei ist die örtliche Anordnung insbesondere derart, dass in einer Projektion einer Draufsicht auf die zuvor genannte Substratoberfläche die erste Bondverbindungsstelle lateral innerhalb des jeweiligen Substratverbindungsbereiches des Trägersubstrates der ersten und/oder der zweiten Elektronikbaugruppe angeordnet ist. Auf diese Weise wirken die Verbindungsdome während eines Bondprozesses in der Funktion von mechanischen Stützelementen, durch welche die beim Bonden wirkenden Kräfte schadfrei aufgenommen werden können.

Zur vereinfachten Ausführung und Anwendung einer Bondprozesstechnik ist auf der dem Substratverbindungsbereich zugewandten Substratoberfläche des Trägersubstrates der ersten Elektronikbaugruppe eine zweite Bondverbindungsstelle des elektrisch leitfähigen Verbindungselementes ausgebildet, wobei in einer Draufsicht auf die erste Bondverbindungsstelle die zweite Bondverbindungsstelle lateral versetzt zu einer Außenkante des Trägersubstrates der zweiten Elektronikbaugruppe frei zugänglich angeordnet ist. Dies erfolgt in einer solche Ausführung, dass die zweite Bondverbindungsstelle insbesondere frei zugänglich für ein Bondwerkzeug ist. Das Bonden kann demnach erfolgen, nachdem die Elektronikanordnung als geklebter Verbund von zwei Elektronikbaugruppen vorliegt. Ferner ist es damit auch ermöglicht, das Bonden über unterschiedliche Ebenen der angeordneten Trägersubstrate beider Elektronikbaugruppen auszuführen.

Hierbei können beide Bondverbindungsstellen mit zumindest einem Teil der elektrischen Leitstruktur der jeweiligen Elektronikbaugrippe verbunden sein. Beispielsweise umfasst die erste Bondverbindungsstelle ein Kontaktpad des Trägersubstrates der zweiten Elektronikbaugruppe und die zweite Bondverbindungsstelle umfasst ein Kontaktpad des Trägersubstrates der ersten Elektronikbaugruppe. Alternativ ist die zweite Bondverbindungsstelle mit einem Kontaktanschluss eines auf dem Trägersubstrat der ersten Elektronikbaugruppe angeordneten Leistungshalbleiters verbunden.

In einer besonderen Weiterbildung der Elektronikanordnung weist das Trägersubstrat der zweiten Elektronikbaugruppe randseitig zumindest eine einseitig oder zweiseitig geöffnete Aussparung auf, wobei in einer Projektion einer Draufsicht auf die gebondete Substratoberfläche des Trägersubstrates der zweiten Elektronikbaugruppe die zweite Bondverbindungsstelle lateral innerhalb der Aussparung angeordnet ist. Auf diese Weise kann eine sehr kompakte Schaltungsanordnung sowohl der ersten Elektronikbaugruppe als auch der zweiten Elektronikbaugruppe umgesetzt werden. Bevorzugt weist ein zur Aussparung benachbarter Bereich des Trägersubstrats der zweiten Elektronikbaugruppe dann eine erste Bondverbindungsstelle auf. Weiter bevorzugt ist unterhalb der ersten Bondverbindungsstelle der Klebeverbund von jeweils zwei Verbindungsdomen als zusätzliche mechanische Stützelemente für einen Bondprozess angeordnet.

Allgemein können eine Vielzahl von paarweise verklebten Verbindungsdomen der ersten bzw. zweiten Elektronikbaugruppe innerhalb der Elektronikanordnung ausgebildet sein. Bevorzugt sind alle Verbindungsdome einer oder beider Elektronikbaugruppen oder ist zumindest die Mehrzahl von Verbindungsdomen einer oder beider Elektronikbaugruppen gleich ausgeführt. Davon abweichend können sich zumindest zwei Verbindungdome innerhalb einer Elektronikbaugruppe und/oder zwischen beiden Elektronikbaugruppen unterscheiden, um lokalen Erfordernissen gerecht zu werden.

Zusätzlich können mehrere Fügepartner, umfassend zumindest eine oder mehrere einer beschriebenen Ausführung der Elektronikbaugruppe, nebeneinander und/oder übereinander angeordnet als Verbundanordnung mittels Strukturklebungen zwischen komplementären Verbindungsdomen jeweils zweier Fügepartner ausgeführt sein.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine Elektronikanordnung umfassend zumindest eine Elektronikbaugruppe und einen mit dieser verklebten Fügepartner in einer seitlichen Schnittdarstellung,
- Fig. 2:: die Elektronikanordnung aus Fig. 1 in einer Draufsicht.

### Ausführungsformen der Erfindung

In den Figuren sind funktional gleiche Bauelemente jeweils mit gleichen Bezugszeichen gekennzeichnet.

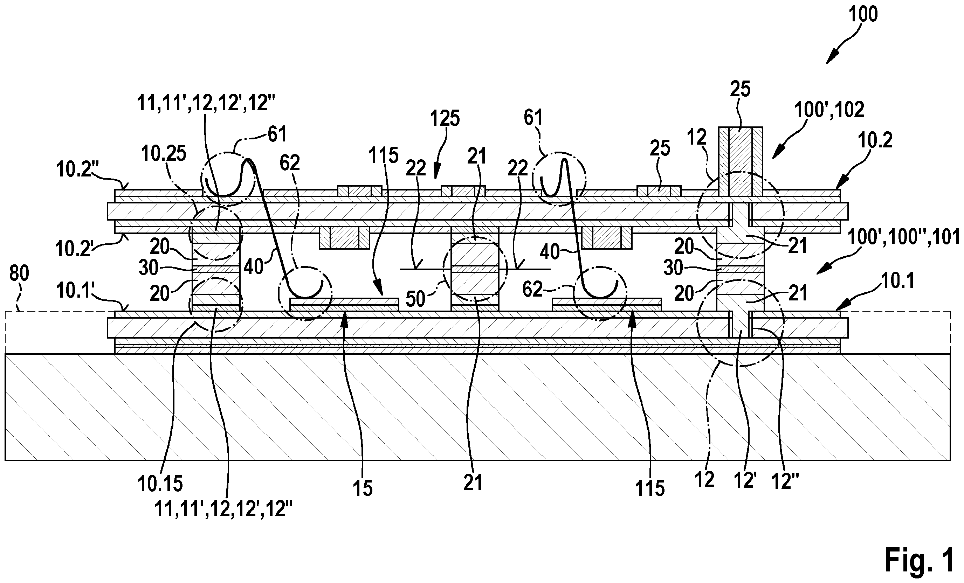

In der Fig. 1 ist eine beispielhafte Ausführung einer Elektronikanordnung 100 in einer seitlichen Schnittdarstellung gezeigt. Die Elektronikanordnung 100 umfasst zumindest eine Elektronikbaugruppe 100' mit einem zumindest einseitig bestückten Trägersubstrat 10.1, 10.2 und einen mit der Elektronikbaugruppe 100' mittels einer Klebverbindung verbundenen Fügepartner 100". Insbesondere ist eine beispielhafte Ausführung gezeigt, bei welcher eine erste Elektronikbaugruppe 101 und eine zweite Elektronikbaugruppe 102 übereinander angeordnet sind, so dass Trägersubstratoberflächen 10.1 `, 10.2' der jeweiligen Elektronikbaugruppen 101, 102 zueinander beabstandet parallel zugewandt sind. Die zueinander zugewandten Trägersubstratoberflächen 10.1', 10.2' weisen zumindest einen von der Trägersubstratoberfläche 10.1', 10.2' abstehenden Verbindungsdom 20 auf, welcher mit der jeweiligen Trägersubstrat 10.1, 10.2 in einem Substratverbindungsbereich 10.15, 10.25 verbunden ist, beispielsweise mittels einer Lotschicht 11 oder einer Sinterschicht 11'. Alternativ liegt eine feste Verbindung mittels eines Einpresskontaktes 12 vor, beispielsweise umfassend einen Einpressstift 12' und eine Einpressbohrung 12", die komplementär zueinander in dem Verbindungsdom 20 bzw. dem Trägersubstrat 10.1, 10.2 angeformt bzw. ausgeformt sind (exemplarisch in der Fig. 1 an den zwei Verbindungsdomen 20 außen rechts in der Elektronikanordnung dargestellt). In einem Verbindungsbereich 50 stehen sich die jeweiligen Endbereiche zweier Verbindungsdome 20 der ersten und der zweiten Elektronikbaugruppe 101, 102 gegenüber. Diese sich zugewandten Endbereiche weisen dabei jeweils eine abschließende Grenzschicht aus einem Metalloxid auf, welche ausgebildet ist, eine Klebehaftfläche 22 für eine Kleberschicht 30 bereitzustellen zur Ausbildung einer geklebten Verbundanordnung mit einem Fügepartner. Beide Klebehaftflächen 22 beider Verbindungsdomen 20 sind mittels einer an diese angrenzende und an diese fest anhaftenden Klebeschicht 30 miteinander verbunden. Im vorliegenden Ausführungsbeispiel sind in der Schnittdarstellung drei klebverbundene komplementäre Verbindungsdome 20 gezeigt. Alternativ können mehr oder weniger Paare anwendungsspezifisch vorgesehen sein.

Bevorzugt sind die Verbindungsdome aus einem Aluminium, einer Aluminiumlegierung oder einem Aluminiumoxid ausgebildet. Im Verbindungsbereich 50 ist damit eine Grenzschicht mit einem für die Klebverbindung erforderlichem Oxid sichergestellt. Im Substratverbindungsbereich 10.15, 10.25 weist der jeweilige Verbindungsdom 20 eine zusätzliche Metallisierung 21 auf, beispielsweise aus Ag, Cu, Ni, Au oder einer ihrer Legierungen auf. Insbesondere weist die Metallisierung 21 hierbei zumindest eine sinterbare und/oder lötbare Grenzschicht auf. Die Metallisierung 21 ist beispielsweise galvanisch aufgebracht. Alternativ kann im Substratverbindungsbereich 10.15, 10.25 ein Kupferblech als die Metallisierung 21 an den aluminiumhaltigen Kern des Verbindungdomes 20 walzplattiert verbunden sein. Das Kupferblech weist dann alternativ eine Ausformung bzw. Anformung eines Einpresspins 12' bzw. einer Einpressbohrung 12" auf. Grundsätzlich kann der Verbindungsdom 20 auch aus einem beliebigen, insbesondere metallischen Kernmaterial bestehen, welcher im Substratverbindungsbereich 10.15, 10.25 eine sinter- und/oder lötbare Beschichtung und im Verbindungsbereich 50 eine klebbare Beschichtung aus einem Metalloxid aufweist.

Die erste und die zweite Elektronikbaugruppe 101, 102 weisen jeweils eine elektronische Schaltung 115, 125 auf. Diese sind mittels zumindest eines elektrisch leitfähigen Verbindungselementes 40, insbesondere einem Bonddraht oder einem Bondbändchen, elektrisch miteinander verbunden sind. Die erste Elektronikbaugruppe 101 weist bevorzugt eine Leistungsschaltung 115 auf mit zumindest einem Leistungshalbleiter 15, welcher auf einem DBC-, AMB-, IMS-, LTCC- oder HTCC-Substrat 10.1 angeordnet ist, beispielsweise verlötet oder versintert. Weiter bevorzugt weist die zweite Elektronikbaugruppe 102 eine Ansteuerschaltung 125 der Leistungsschaltung 115 auf mit zumindest einem verlöteten oder versinterten elektrischen und/oder elektronischen Bauelement 25. Das elektrische und/oder elektronische Bauelement 25 ist dabei insbesondere auf einer Leiterplatte als dem Trägersubstrat 10.2 angeordnet, beispielsweise einer Standard-F4-Leiterplatte. Auf der dem Substratverbindungsbereich 10.25 abgewandten Substratoberfläche 10.2" des Trägersubstrates 10.2 der zweiten Elektronikbaugruppe 102 ist eine erste Bondverbindungsstelle 61 des elektrisch leitfähigen Verbindungselementes 40 ausgebildet. Die erste Bondverbindungsstelle 61 ist dabei direkt oberhalb der klebverbundenen Verbindungsdome 20 angeordnet, so dass bei einem Bondprozess einwirkende mechanische Kräfte stützend aufgenommen werden können. Die Bondverbindung erfolgt beispielsweise auf einem dafür vorgesehenen metallischen Kontaktpad, welches strukturgleich oder -ähnlich wie eine auf der Trägersubstratoberfläche 10.2' angeordnete elektrische Leiterstruktur ausgebildet ist.

Auf der dem Substratverbindungsbereich 10.15 zugewandten Substratoberfläche 10.1' des Trägersubstrates 10.1 der ersten Elektronikbaugruppe 101 ist dagegen eine zweite Bondverbindungsstelle 62 des elektrisch leitfähigen Verbindungselementes 40 ausgebildet. Die Bondverbindung erfolgt in diesem Ausführungsbeispiel mit einem Oberkontaktanschluss eines auf dem Trägersubstrat 10.1 der ersten Elektronikbaugruppe 101 angeordneten Leistungshalbleiters 15. Alternativ kann auch eine Bondverbindung mit einem Kontaktpad erfolgen, ähnlich oder gleich wie bei der ersten Bondverbindungsstelle 61. Es können, wie in Fig. 1 dargestellt, beide Schaltungen 115, 125 mit mehr als einem Verbindungselement 40 miteinander verbunden sein.

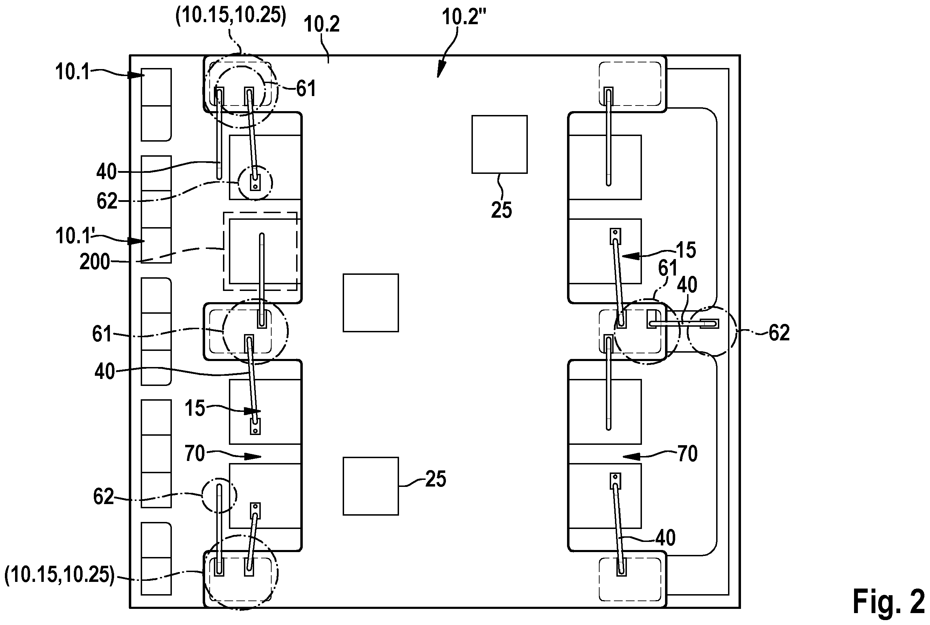

In der Fig. 2 ist die Elektronikanordnung aus Fig. 1 in einer Draufsicht gezeigt. Zu erkennen ist dabei, dass in einer Projektion der Draufsicht auf die Trägersubstratoberfläche 10.2" die erste Bondverbindungsstelle 61 lateral innerhalb des jeweiligen Substratverbindungsbereiches 10.15, 10.25 des Trägersubstrates 10.1, 10.2 der ersten und/oder der zweiten Elektronikbaugruppe 101, 102 angeordnet ist. Zusätzlich ist zu erkennen, dass in einer Draufsicht auf die erste Bondverbindungsstelle 61 die zweite Bondverbindungsstelle 62 lateral versetzt zu einer Außenkante des Trägersubstrates 10.2 der zweiten Elektronikbaugruppe 102 frei zugänglich angeordnet ist, insbesondere frei zugänglich für ein Bondwerkzeug 200 (gestrichelt dargestellt). Zur Ausführung einer kompakten Elektronikbaugruppe 101, 102 weist in diesem Ausführungsbeispiel das Trägersubstrat 10.2 der zweiten Elektronikbaugruppe 102 randseitig zumindest eine einseitig oder zweiseitig geöffnete Aussparung 70 auf. In einer Projektion der Draufsicht auf die gebondete Trägersubstratoberfläche 10.2' des Trägersubstrates 10.2 der zweiten Elektronikbaugruppe 102 ist erkennbar, dass die zweite Bondverbindungsstelle 62 dabei lateral innerhalb der Aussparung 70 angeordnet ist.

Eine weitere Ausführung einer Elektronikanordnung 100 ergibt dadurch, dass eine Elektronikbaugruppe 100' statt, wie bereits beschrieben, mit einer anderen Elektronikbaugruppe 100' nun mit einem anderen Fügepartner 100" verbunden ist, wobei der andere Fügepartner 100" eine klebbare Fügeoberfläche aufweist. Diese kann wiederum durch einen Verbindungsdom 20 bereitgestellt sein, welcher mit dem Fügepartner 100" einstückig ausgebildet ist oder mit diesem verbunden ist. In der Fig. 1 ist daher eine weitere Elektronikanordnung 100 sichtbar, bei welcher beispielsweise die Elektronikbaugruppe 102 statt mit der Elektronikbaugruppe 102 nun mit einem Gehäuseteil 80 strukturgeklebt ist. Bevorzugt ist das Gehäuseteil aus Aluminium oder einer Aluminiumlegierung, so dass dort ausgeformte oder angeordnete Verbindungsdome eine Grenzschicht aus Al-Oxid aufweisen. Alternativ kann bei einem anderen Gehäusematerial entsprechende Verbindungsdome 20 angeordnet sein, die paarweise mit einem Verbindungsdom 20 der zweiten Elektronikbaugruppe 102 eine geklebte Verbundanordnung ausbilden.

Grundsätzlich können auf dem Verbindungsdom eines der Fügepartner 101, 102, 70 Klebstoff auf der Klebehaftfläche 22 aufgebracht werden, beispielsweise durch einen Dispensvorgang. Daraufhin kann der andere Fügepartner 101, 102, 70 in eine Anordnung gebracht werden, beispielsweise durch eine Handlingvorrichtung, in welcher paarweise Verbindungsdome 20 der jeweiligen Fügepartner 101, 102, 70 mit ihren Klebehaftflächen 22 sich gegenüberstehen und jeweils von dem Klebstoff unter Ausbildung der angrenzenden Kleberschicht 30 benetzt sind. Es ergibt sich eine Last übertragende Klebeverbindung, sobald der Klebstoff ausgehärtet ist.

## Patentansprüche

1. Elektronikbaugruppe (100', 101, 102) umfassend zumindest ein Trägersubstrat (10.1, 10.2), wobei auf zumindest einer Trägersubstratoberfläche (10. 1', 10.2') eine elektronische Schaltung (115, 125) ausgebildet ist, wobei die Elektronikbaugruppe (10.1, 10.2) zumindest einen mechanischen Verbindungsdom (20) umfasst, welcher in einem Substratverbindungsbereich (10.15, 10.25) mit zumindest einer der Trägersubstratoberflächen (10.1', 10.2') verbunden ist, **dadurch gekennzeichnet, dass** der Verbindungsdom (20) auf einer dem Substratverbindungsbereich (10.15, 10.25) abgewandten Seite eine abschließende Grenzschicht aus einem Metalloxid aufweist, welche ausgebildet ist, eine Klebehaftfläche (22) für eine Kleberschicht (30) bereitzustellen zur Ausbildung einer geklebten Verbundanordnung mit einem Fügepartner (100").

2. Elektronikbaugruppe (100', 101, 102) nach Anspruch 1,
**dadurch gekennzeichnet, dass**
der Verbindungsdom (20) im Wesentlichen oder zumindest auf einer der bereitgestellten Klebehaftfläche (22) zugewandten Seite anteilig aus Aluminium oder einer Aluminiumlegierung, insbesondere einem Aluminiumoxid, gebildet ist.

3. Elektronikbaugruppe (100', 101, 102) nach einem der Ansprüche 1 oder 2,
**dadurch gekennzeichnet, dass**
der Verbindungsdom (20) zumindest auf der dem Substratverbindungsbereich (10.15, 10.25) zugewandten Seite eine aufgebrachte, festhaftende Metallisierung (21) aufweist, insbesondere aus Cu, Ag, Ni, Au oder aus einer ihrer Legierungen.

4. Elektronikbaugruppe (100', 101, 102) nach Anspruch 3,
**dadurch gekennzeichnet, dass**
die Metallisierung (21) galvanisch aufgebracht ist, beispielsweise aus Ag, oder als walzplattiertes Blech aufgebracht ist, beispielsweise ein Cu-Blech.

5. Elektronikbaugruppe (100', 101, 102) nach einem der vorhergehenden Ansprüche,
**dadurch gekennzeichnet, dass**
der Verbindungsdom (20) mittels einer Lotschicht (11) oder einer Sinterschicht (11') im Substratverbindungsbereich (10.15, 10.25) mit dem Trägersubstrat (10.1 , 10.2) verbunden ist, wobei der Verbindungsdom (20) zumindest im Substratverbindungsbereich (10.15, 10.25) eine zur Lotschicht (11) oder zur Sinterschicht (11') abschließende lötbare und/oder sinterbare Grenzschicht aufweist.

6. Elektronikbaugruppe (100', 101, 102) nach einem der Ansprüche 1 bis 4,
**dadurch gekennzeichnet, dass**
der Verbindungsdom (20) mittels einer kraftschlüssigen und/oder einer formschlüssigen Verbindung, insbesondere einem Einpresskontakt (12), im Substratverbindungsbereich (10.15, 10.25) mit dem Trägersubstrat (10.1, 10.2) verbunden ist.

7. Elektronikanordnung (100) umfassend zumindest eine erste Elektronikbaugruppe (101, 102) nach einem der Ansprüche 1 bis 6 und einem Fügepartner (100"), wobei in einem Verbindungsbereich (50) der Fügepartner (100") zumindest mit dem einen Verbindungsdom (20) mittels einer an die jeweils bereitgestellte Klebehaftfläche (22) unmittelbar angrenzenden Klebeschicht (30) verbunden ist.

8. Elektronikanordnung (100) nach Anspruch 7,
**dadurch gekennzeichnet, dass**
der Fügepartner (100") ein Gehäuseteil (80) ist oder zumindest eine zweite Elektronikbaugruppe (101, 102) nach einem der Ansprüche 1 bis 6 ist, wobei die zwei Elektronikbaugruppen (101, 102) übereinander angeordnet sind und der Verbindungsbereich (50) zwischen zwei zueinander zugewandten Klebehaftflächen (22) von jeweils einem Verbindungsdom (20) der ersten und der zweiten Elektronikbaugruppe (101, 102) ausgebildet ist.

9. Elektronikanordnung (100) nach Anspruch 8,
**dadurch gekennzeichnet, dass**
die zwei verklebten Verbindungsdome (20) jeweils mit Substratoberflächen (10.1', 10.2') der Trägersubstrate (10.1, 10.2) der ersten und der zweiten Elektronikbaugruppe (101, 102) verbunden sind, die parallel zueinander angeordnet sind.

10. Elektronikanordnung (100) nach einem der Ansprüche 8 oder 9,
**dadurch gekennzeichnet, dass**
die elektronischen Schaltungen (115, 125) der ersten und der zweiten Elektronikbaugruppe (101, 102) mittels zumindest eines elektrisch leitfähigen Verbindungselementes (40) elektrisch miteinander verbunden sind, wobei bevorzugt die erste Elektronikbaugruppe (101) eine Leistungsschaltung (115) aufweist und die zweite Elektronikbaugruppe (102) eine Ansteuerschaltung (125) der Leistungsschaltung (115) aufweist.

11. Elektronikanordnung (100) nach Anspruch 10,
**dadurch gekennzeichnet, dass**
das elektrische leitfähige Verbindungselement (40) ein Bonddraht oder ein Bondbändchen ist.

12. Elektronikanordnung (100) nach Anspruch 11,
**dadurch gekennzeichnet, dass**
die Trägersubstrate (10.1, 10.2) der ersten und der zweiten Elektronikbaugruppe (101, 102) parallel übereinander angeordnet sind und auf der dem Substratverbindungsbereich (10.15, 10.25) abgewandten Substratoberfläche (10.2") des Trägersubstrates (10.2) der zweiten Elektronikbaugruppe (102) eine erste Bondverbindungsstelle (61) des elektrisch leitfähigen Verbindungselementes (40) ausgebildet ist, wobei in einer Projektion einer Draufsicht auf die zuvor genannte Substratoberfläche (10.2") die erste Bondverbindungsstelle (61) lateral innerhalb des jeweiligen Substratverbindungsbereiches (10.15, 10.25) des Trägersubstrates (10.1, 10.2) der ersten und/oder der zweiten Elektronikbaugruppe (101, 102) angeordnet ist.

13. Elektronikanordnung (100) nach einem der Ansprüche 11 oder 12,
**dadurch gekennzeichnet, dass**
auf der dem Substratverbindungsbereich (10.15, 10.25) zugewandten Substratoberfläche (10.1') des Trägersubstrates (10.1) der ersten Elektronikbaugruppe (101) eine zweite Bondverbindungsstelle (62) des elektrisch leitfähigen Verbindungselementes (40) ausgebildet ist, wobei in einer Draufsicht auf die erste Bondverbindungsstelle (61) die zweite Bondverbindungsstelle (62) lateral versetzt zu einer Außenkante des Trägersubstrates (10.2) der zweiten Elektronikbaugruppe (102) frei zugänglich angeordnet ist, insbesondere frei zugänglich für ein Bondwerkzeug (200).

14. Elektronikanordnung (100) nach einem der Ansprüche 12 oder 13,
**dadurch gekennzeichnet, dass**
die erste Bondverbindungsstelle (61) ein Kontaktpad des Trägersubstrates (10.2) der zweiten Elektronikbaugruppe (102) umfasst und die zweite Bondverbindungsstelle (62) ein Kontaktpad des Trägersubstrates (10.1) der ersten Elektronikbaugruppe (101) oder einen Oberkontaktanschluss eines auf dem Trägersubstrat der ersten Elektronikbaugruppe (101) angeordneten Leistungshalbleiters (15) umfasst.

15. Elektronikanordnung (100) nach einem der Ansprüche 12 bis 14,
**dadurch gekennzeichnet, dass**
das Trägersubstrat (10.2) der zweiten Elektronikbaugruppe (102) randseitig zumindest eine einseitig oder zweiseitig geöffnete Aussparung (70) aufweist, wobei in einer Projektion einer Draufsicht auf die gebondete Substratoberfläche (10.2") des Trägersubstrates (10.2) der zweiten Elektronikbaugruppe (102) die zweite Bondverbindungsstelle (62) lateral innerhalb der Aussparung (70) angeordnet ist.

## Claims

1. Electronics assembly (100', 101, 102) comprising at least one carrier substrate (10.1, 10.2), wherein an electronic circuit (115, 125) is formed on at least one carrier substrate surface (10.1', 10.2'), wherein the electronics assembly (10.1, 10.2) comprises at least one mechanical connecting dome (20) which is connected to at least one of the carrier substrate surfaces (10.1', 10.2') in a substrate connecting region (10.15, 10.25), **characterized in that** the connecting dome (20) has, on a side facing away from the substrate connecting region (10.15, 10.25), a terminating boundary layer which is composed of a metal oxide and is designed to provide an adhesion area (22) for an adhesive layer (30) for forming an adhesively bonded composite arrangement with a joining partner (100").

2. Electronics assembly (100', 101, 102) according to Claim 1, **characterized in that** the connecting dome (20) is formed proportionally from aluminium or an aluminium alloy, in particular an aluminium oxide, substantially or at least on a side facing the adhesion area (22) provided.

3. Electronics assembly (100', 101, 102) according to either of Claims 1 and 2, **characterized in that** the connecting dome (20) has, at least on that side which faces the substrate connecting region (10.15, 10.25), an applied, firmly adhering metallization (21), in particular composed of copper, silver, nickel, gold or from one of their alloys.

4. Electronics assembly (100', 101, 102) according to Claim 3, **characterized in that** the metallization (21) is applied by electroplating, for example using gold, or as a roll-bonded clad metal sheet, for example a copper sheet.

5. Electronics assembly (100', 101, 102) according to one of the preceding claims, **characterized in that** the connecting dome (20) is connected to the carrier substrate (10.1, 10.2) by means of a soldered layer (11) or a sintered layer (11') in the substrate connecting region (10.15, 10.25), wherein the connecting dome (20) has, at least in the substrate connecting region (10.15, 10.25), a solderable and/or sinterable boundary layer which provides termination with respect to the soldered layer (11) or with respect to the sintered layer (11').

6. Electronics assembly (100', 101, 102) according to one of Claims 1 to 4, **characterized in that** the connecting dome (20) is connected to the carrier substrate (10.1, 10.2) by means of a non-positive and/or a positive connection, in particular a press-in contact (12), in the substrate connecting region (10.15, 10.25).

7. Electronics arrangement (100) comprising at least one first electronics assembly (101, 102) according to one of Claims 1 to 6 and a joining partner (100''), wherein, in a connecting region (50), the joining partner (100") is connected at least to the one connecting dome (20) by means of an adhesive layer (30) directly adjoining the respectively provided adhesion area (22).

8. Electronics arrangement (100) according to Claim 7, **characterized in that** the joining partner (100'') is a housing part (80) or is at least one second electronics assembly (101, 102) according to one of Claims 1 to 6, wherein the two electronics assemblies (101, 102) are arranged one above the other and the connecting region (50) is formed between two mutually facing adhesion areas (22) of in each case one connecting dome (20) of the first and the second electronics assembly (101, 102).

9. Electronics arrangement (100) according to Claim 8, **characterized in that** the two adhesively bonded connecting domes (20) are each connected to substrate surfaces (10.1', 10.2') of the carrier substrates (10.1, 10.2) of the first and the second electronics assembly (101, 102) which are arranged parallel to one another.

10. Electronics arrangement (100) according to either of Claims 8 and 9, **characterized in that** the electronic circuits (115, 125) of the first and the second electronics assembly (101, 102) are electrically connected to one another by means of at least one electrically conductive connecting element (40), wherein the first electronics assembly (101) preferably has a power circuit (115) and the second electronics assembly (102) has a drive circuit (125) of the power circuit (115) .

11. Electronics arrangement (100) according to Claim 10, **characterized in that** the electrically conductive connecting element (40) is a bonding wire or a bonding ribbon.

12. Electronics arrangement (100) according to Claim 11, **characterized in that** the carrier substrates (10.1, 10.2) of the first and the second electronics assembly (101, 102) are arranged one above the other in parallel and a first bonding connection point (61) of the electrically conductive connecting element (40) is arranged on the substrate surface (10.2"), facing away from the substrate connecting region (10.15, 10.25), of the carrier substrate (10.2) of the second electronics assembly (102), wherein, in a projection of a plan view of the above-mentioned substrate surface (10.2''), the first bonding connecting point (61) is arranged laterally inside the respective substrate connecting region (10.15, 10.25) of the carrier substrate (10.1, 10.2) of the first and/or the second electronics assembly (101, 102).

13. Electronics arrangement (100) according to either of Claims 11 and 12, **characterized in that** a second electronics bonding connecting point (62) of the electrically conductive connecting element (40) is formed on the substrate surface (10.1) of the carrier substrate (10.1) of the first electronics assembly (101), wherein, in a plan view of the first bonding connecting point (61), the second bonding connecting point (62) is arranged in a freely accessible manner laterally offset with respect to an outer edge of the carrier substrate (10.2) of the second electronics assembly (102), in particular in a manner freely accessible to a bonding tool (200).

14. Electronics arrangement (100) according to either of Claims 12 and 13, **characterized in that** the first bonding connecting point (61) comprises a contact pad of the carrier substrate (10.2) of the second electronics assembly (102), and the second bonding connecting point (62) comprises a contact pad of the carrier substrate (10.1) of the first electronics assembly (101) or an upper contact connection of a power semiconductor (15) arranged on the carrier substrate of the first electronics assembly (101).

15. Electronics arrangement (100) according to one of Claims 12 to 14, **characterized in that** the carrier substrate (10.2) of the second electronics assembly (102) has, at the edge, at least one cutout (70) which is open on one side or two sides, wherein, in a projection of a plan view of the bonded substrate surface (10.2") of the carrier substrate (10.2) of the second electronics assembly (102), the second bonding connecting point (62) is arranged laterally inside the cutout (70).

## Revendications

1. Module électronique (100', 101, 102) comprenant au moins un substrat de support (10.1, 10.2), un circuit électronique (115, 125) étant formé sur au moins une surface (10.1', 10.2') du substrat de support,
le module électronique (10.1, 10.2) comprenant au moins un dôme de liaison mécanique (20) qui est relié à au moins une des surfaces (10.1', 10.2') du substrat de support dans une zone de liaison de substrat (10.15, 10.25), **caractérisé en ce que**
le dôme de liaison (20) comporte, sur un côté opposé à la zone de liaison de substrat (10.15, 10.25), une couche limite d'obturation en oxyde métallique, laquelle est conçue pour fournir une surface adhésive (22) destinée à une couche d'adhésif (30) afin de former un ensemble composite collé avec un partenaire de jonction (100'').

2. Module électronique (100', 101, 102) selon la revendication 1,
**caractérisé en ce que**
le dôme de liaison (20) est formé en proportion en aluminium ou en alliage d'aluminium, en particulier en oxyde d'aluminium sensiblement ou au moins partiellement sur un côté, dirigé vers la surface adhésive fournie (22).

3. Module électronique (100', 101, 102) selon l'une des revendications 1 et 2,
**caractérisé en ce que**
le dôme de liaison (20) comporte, au moins du côté dirigé vers la zone de liaison substrat (10.15, 10.25), une métallisation (21), appliquée et adhérente, notamment en Cu, Ag, Ni, Au ou l'un de leurs alliages.

4. Module électronique (100', 101, 102) selon la revendication 3,
**caractérisé en ce que**
la métallisation (21) est appliquée galvaniquement, par exemple à partir d'Ag, ou est appliquée sous forme de tôle laminée, par exemple une tôle de Cu.

5. Module électronique (100', 101, 102) selon l'une des revendications précédentes,
**caractérisé en ce que**
le dôme de liaison (20) est relié au substrat de support (10.1, 10.2) au moyen d'une couche de brasage (11) ou d'une couche frittée (11') dans la zone de liaison de substrat (10.15, 10.25), le dôme de liaison (20) comportant, au moins dans la zone de liaison de substrat (10.15, 10.25), une couche limite d'obturation brasable et/ou frittable par rapport à la couche de brasage (11) ou la couche de frittage (11').

6. Module électronique (100', 101, 102) selon l'une des revendications 1 à 4,
**caractérisé en ce que**
le dôme de liaison (20) est relié au substrat de support (10.1, 10.2) dans la zone de liaison de substrat (10.15, 10.25) au moyen d'une liaison en force et/ou d'une liaison par complémentarité de formes, en particulier d'un contact à pression (12).

7. Ensemble électronique (100) comprenant au moins un premier module électronique (101, 102) selon l'une des revendications 1 à 6 et un partenaire de jonction (100''), le partenaire de jonction (100'') étant relié, dans une zone de liaison (50), au moins à l'un des dômes de liaison (20) au moyen d'une couche adhésive (30) directement adjacente à la surface adhésive respectivement fournie (22).

8. Ensemble électronique (100) selon la revendication 7,
**caractérisé en ce que**
le partenaire de jonction (100") est une partie de boîtier (80) ou est au moins un deuxième module électronique (101, 102) selon l'une des revendications 1 à 6, les deux modules électroniques (101, 102) étant disposés l'un au-dessus de l'autre et la zone de liaison (50) étant formée entre deux surfaces adhésives (22), dirigées l'une vers l'autre, d'un dôme de liaison respectif (20) des premier et deuxième modules électroniques (101, 102).

9. Ensemble électronique (100) selon la revendication 8,
**caractérisé en ce que**
les deux dômes de liaison collés (20) sont reliés respectivement à des surfaces de substrat (10-1'. 10.2') des substrats de support (10.1, 10.2) des premier et deuxième modules électroniques (101, 102) qui sont disposés parallèlement l'un à l'autre.

10. Ensemble électronique (100) selon l'une des revendications 8 et 9,
**caractérisé en ce que**
les circuits électroniques (115, 125) des premier et deuxième modules électroniques (101, 102) sont reliés électriquement entre eux au moyen d'au moins un élément de liaison électriquement conducteur (40), de préférence le premier module électronique (101) comportant un circuit de puissance (115) et le deuxième module électronique (102) comportant un circuit de commande (125) du circuit de puissance (115).

11. Ensemble électronique (100) selon la revendication 10,
**caractérisé en ce que**
l'élément de liaison électriquement conducteur (40) est un fil de métallisation ou un ruban de métallisation.

12. Ensemble électronique (100) selon la revendication 11,
**caractérisé en ce que**
les substrats de support (10.1, 10.2) du premier et du deuxième module électronique (101, 102) sont disposés parallèlement l'un au-dessus de l'autre et un premier point de liaison métallisée (61) de l'élément de liaison électriquement conducteur (40) est formé sur la surface de substrat (10.2"), opposée à la zone de liaison de substrat (10.15, 10.25), du substrat de support (10.2) du deuxième module électronique (102), le premier point de liaison métallisée (61) étant disposé, dans une projection d'une vue de dessus sur la surface de substrat susmentionnée (10.2"), latéralement à l'intérieur de la zone de liaison de substrat respective (10.15, 10.25) du substrat de support (10.1, 10.2) du premier et/ou du deuxième module électronique (101, 102).

13. Ensemble électronique (100) selon l'une des revendications 11 ou 12,
**caractérisé en ce que**
un deuxième point de liaison métallisée (62) de l'élément de liaison électriquement conducteur (40) est formé sur la surface de substrat (10.1'), dirigée vers la zone de liaison de substrat (10.15, 10.25), du substrat de support (10.1) du premier module électronique (101), le deuxième point de liaison métallisée (62) étant disposé, dans une vue de dessus du premier point de liaison métallisée (61), de manière librement accessible, en particulier librement accessible pour un outil de métallisation (200), en étant décalé latéralement d'un bord extérieur du substrat de support (10.2) du deuxième module électronique (102).

14. Ensemble électronique (100) selon l'une des revendications 12 ou 13,
**caractérisé en ce que**
le premier point de liaison métallisée (61) comprend une pastille de contact du substrat de support (10.2) du deuxième module électronique (102) et le deuxième point de liaison métallisée (62) comprend une pastille de contact du substrat de support (10.1) du premier module électronique (101) ou une connexion de contact supérieure d'un semi-conducteur de puissance (15) disposé sur le substrat de support du premier module électronique (101).

15. Ensemble électronique (100) selon l'une des revendications 12 à 14,
**caractérisé en ce que**
le substrat de support (10.2) du deuxième module électronique (102) comporte au moins un évidement (70) ouvert en bordure sur un côté ou sur deux côtés, le deuxième point de liaison métallisée (62) étant disposé, dans une projection d'une vue de dessus de la surface de substrat métallisée (10.2'') du substrat de support (10.2) du deuxième module électronique (102), latéralement à l'intérieur de l'évidement (70).
